# EUROPÄISCHE PATENTSCHRIFT

(11) **EP 2 362 920 B1**
(45) Veröffentlichungstag und Bekanntmachung des Hinweises auf die Patenterteilung: **27.03.2013**
(21) Anmeldenummer: 09793452.5
(22) Anmeldetag: 13.10.2009
(51) Int. Cl.: D02G 3/32, D02G 3/44, D03D 19/00

(54) **LEITFÄHIGES TEXTILES FLÄCHENGEBILDE MIT DREHERBINDUNG**
CONDUCTIVE TEXTILE FABRIC HAVING LENO WEAVE
PRODUIT PLAT TEXTILE CONDUCTEUR AVEC ARMURE GAZE

(30) Priorität: 28.10.2008 DE 102008037488
(43) Veröffentlichungstag der Anmeldung: 07.09.2011
(73) Patentinhaber: W. Zimmermann GmbH & Co. KG, 88171 Weiler-Simmerberg (DE)
(72) Erfinder: NUSKO, Robert, 93109 Wiesent (DE); MAUCH, Hans-Peter, 87509 Immenstadt (DE); MAIER, Georg, 93177 Altentann (DE)
(74) Vertreter: Graf Glück Kritzenberger
(86) Internationale Anmeldenummer: PCT/DE2009/075059
(87) Internationale Veröffentlichungsnummer: WO 2010/048948

(56) Entgegenhaltungen:
- EP-A1- 0 008 806
- WO-A1-2004/027132
- DE-A1- 10 153 248
- DE-C1- 4 019 357
- US-A- 1 977 265
- US-A- 3 472 289
- US-A- 4 926 910
- US-A- 5 421 376

## Beschreibung

### Technisches Gebiet

Die vorliegende Erfindung betrifft leitfähige textile Flächengebilde mit Dreherbindung.

### Stand der Technik

Elektrisch leitfähige Textilien sind aus dem Stand der Technik bekannt. Sie werden unter anderem zum Heizen, zur Übertragung von Strom und Daten sowie als Sensoren genutzt. Wie beispielsweise in der EP 1 537 264 B1 beschrieben stehen zur Herstellung leitfähiger textiler Flächengebilde verschiedene Leitermaterialien wie Drähte oder leitfähige Garne zur Verfügung, die in ein textiles Flächengebilde von unterschiedlicher Aufmachungsform auf unterschiedliche Art und Weise integriert werden können.

In einem aus der DE 10 2005 024 432 A1 bekannten Verfahren erfolgt die Herstellung leitfähiger Textilien beispielsweise mittels Befestigen eines Leiters auf einem textilen Träger durch verschiedene Näh-, Stick- oder Belegtechniken. Vorteilhaft ist hierbei, dass das Trägertextil unterschiedlich beschaffen sein kann und somit auch eine besonders leichte oder löchrige Struktur aufweisen kann. Die auf dem Textil befestigten Leiter können direkt und ohne weitere Kontaktstellen mit einer Stromquelle kontaktiert werden. Die in der DE 10 2005 024 432 A1 beschriebenen Verfahren bringen jedoch den Nachteil einer eher aufwändigen Herstellung in mehreren Arbeitsschritten mit sich. Zudem gehen diese Verfahren mit eingeschränkter Waschbeständigkeit und einer bestimmten Untergrenze der Textildicke einher.

In anderen bekannten Verfahren, wie sie beispielsweise in der DE 20 2006 011 524 U1 beschrieben sind, werden die elektrischen Leiter bereits während dem Flächenbildungsverfahren, also ohne weitere Arbeitsschritte in das Textil integriert. Möglich sind dabei unterschiedliche textile Flächenbildungsverfahren, bei denen mindestens ein elektrischer Leiter eingebracht oder eingearbeitet wird, der ggf. mit einer externen Stromquelle verbunden ist.

Es sind auch Verfahren bekannt, bei denen im Flächenbildungsverfahren statt metallischer Drähte elektrisch leitfähige, textile Garne als Leiter verwendet werden, so dass die entstehenden Textilien gereinigt und je nach Einbringungsform der elektrischen Leiter ohne Schädigung gedehnt werden können. Solche z.B. in der DE 196 12 225 A1 und der DE 103 42 285 B4 beschriebenen Verfahren haben gemeinsam, dass keine interne Kontaktierung mit einem stromzuführenden Leiter vorgesehen ist. Die insbesondere für Heizanwendungen erforderliche Verbindung zwischen dem leitenden Textil und der Stromquelle wird daher über Bänder, Drähte o.ä. hergestellt, die nachträglich auf dem Textil befestigt werden. Die Kontaktierung des aufgebrachten Materials mit dem leitenden Textil stellt eine Fehlerquelle dar, da unter Umständen durch Verschleiß des aufgebrachten Materials oder unsachgemäße Kontaktierung eine partielle Unterbrechung der elektrischen Verbindung auftreten kann. Eine solche Unterbrechung kann zu einem erhöhten Übergangswiderstand zwischen dem Textil und der Zuleitung führen und damit durch unerwünschte örtliche Überhitzung ein Brandrisiko darstellen. Des Weiteren begrenzen sämtliche zusätzlich aufgebrachten Materialien das Textil bezüglich seiner Dicke und bedeuten einen weiteren Arbeitsschritt bei der Herstellung des Textils.

Daneben sind aus der DE 20 216 927 U1 elektrisch leitfähige Textilflächen bekannt, die eingearbeitete elektrische Zuleitungen enthalten. Die eingearbeiteten Leiter sind im Stande, untereinander interne Kontaktstellen zu bilden, so dass eingebrachte Ströme weitergeleitet werden. Dabei ist insbesondere für Heizanwendungen die Qualität der Übergangskontakte von entscheidender Bedeutung, da für eine Heizfunktion hohe Stromstärken eingesetzt werden. Die zu erreichende Kontaktgüte (Widerstand und Stromtragfähigkeit) sinkt bei Flächengebilden, insbesondere in einflächiger dünner Ausführungsform, mit abnehmender Fadendichte bzw. zunehmender Maschenweite. Bei lockeren bzw. löchrigen Geweben und Maschenstoffen leidet die Zuverlässigkeit der Kontakte, da ein geringer Anpressdruck aufgebaut wird. Zusätzliche mechanische Belastungen wie sie in der Weiterverarbeitung, im Gebrauch oder durch Waschvorgänge auftreten, führen zu weiteren Kontaktverlusten. Somit können keine dauerhaft beständigen Kontakte, die für Heizanwendungen geeignet sind, gewährleistet werden.

In anderen bekannten Verfahren, wie in der DE 20 30 204 und der DE 42 39 068 C2 beschrieben, werden lockere textile Strukturen mit eingearbeiteten Drahtleitern, die mechanischen Belastungen oder bestimmten Anwendungen ausgesetzt sind, zusätzlich stabilisiert. Diese weiteren Stabilisierungsprozesse wie z.B. Verkleben an den Kreuzungspunkten oder Einbetten in eine Matrix, bedeuten wiederum einen zusätzlichen Arbeitsschritt und begrenzen das hergestellte Textil in seiner Anwendungsbreite. Eingearbeitete Drahtmaterialien und anschließende Stabilisierungsmaßnahmen stehen dem Erhalt der typischen textilen Eigenschaften wie z.B. der textilen Haptik für Anwendungen beispielsweise im Bekleidungsbereich entgegen.

Die US 3,472,289 beschreibt ein elektrisch leitfähiges textiles Flächengebilde zum Einsatz als textile Heizung mit zwei in das Flächengebilde integrierten Zuleitern und einem Heizleiter, wobei beide Zuleiter mit dem Heizleiter in elektrisch leitendem Kontakt stehen. Als Heizleiter wird ein elektrisch leitfähiges Kombinationsgarn eingesetzt, das einen Kernfaden und einen um den Kernfaden gewundenen elektrisch leitfähigen Faden umfasst. Als Kernfaden wird ein Kunststoff- oder ein Glas-Faden verwendet. Die Heizleiter sind durch eine Dreherbindung in das Gewebe integriert.

Mit den bekannten Verfahren sind demnach keine einflächigen textilen Strukturen mit großer Maschenweite herstellbar, die ohne Stabilisierung so belastbar sind, dass ihre Kontaktgüte für Heizanwendungen aufrecht erhalten bleibt. Demnach können typische textile Eigenschaften wie mechanische Belastbarkeit, Knickbeständigkeit, Reinigungsbeständigkeit, textiler Griff u.a. in leichten bzw. löchrigen elektrisch leitfähigen Textilien bislang nicht erreicht werden, insbesondere elastische Eigenschaften können nicht verwirklicht werden.

Es besteht daher ein Bedarf an elektrisch leitfähigen Textilien, bei denen die Leiter bereits während der Flächenbildung integriert werden und die ausgezeichnete interne Kontakte zwischen den Leitern aufweisen.

### Darstellung der Erfindung

Hier setzt die Erfindung an. Der Erfindung, wie sie in den Ansprüchen gekennzeichnet ist, liegt die Aufgabe zu Grunde, ein textiles Flächengebilde bereitzustellen, in das die elektrischen Leiter während der Flächenbildung integriert werden und in dem sehr gute elektrische Kontakte zwischen den Zuleitern und den Heizleitern vorliegen.

Diese Aufgabe wird erfindungsgemäß durch das leitfähige textile Flächengebilde gemäß Anspruch 1 gelöst. Weitere vorteilhafte Details, Aspekte und Ausgestaltungen der vorliegenden Erfindung ergeben sich aus den abhängigen Ansprüchen, der Beschreibung, den Beispielen und der Zeichnung.

Das erfindungsgemäße elektrisch leitfähige textile Flächengebilde zum Einsatz als textile Heizung umfasst zwei in definiertem Abstand zueinander als Zuleiter-Garne in das Flächengebilde integrierten Buzz-Bars und mindestens ein Heizleiter-Garn, wobei beide Buzz-Bars mit dem mindestens einem Heizleiter-Garn in elektrisch leitendem Kontakt stehen. Das Heizleiter-Garn weist einen höheren elektrischen Widerstand auf als die Zuleiter-Garne. Bei dem mindestens einen Heizleiter-Garn handelt es sich um ein elektrisch leitfähiges Kombinationsgarn, das zumindest einen Kernfaden und zumindest einen um den Kernfaden gewundenen elektrisch leitfähigen Faden umfasst, wobei der Kernfaden aus einem Elastomer besteht. Das Heizleiter-Garn und die Zuleiter-Garne sind über eine Dreherbindung in einem beständigen Kontakt miteinander verbunden.

Eine Dreherbindung im Sinne der Erfindung liegt vor, wenn sich im Gegensatz zur herkömmlichen Gewebebindung, bei der nur das Kettfadensystem mit den Schussfäden verkreuzt wird, zusätzlich die Kettfäden gegeneinander verkreuzen.

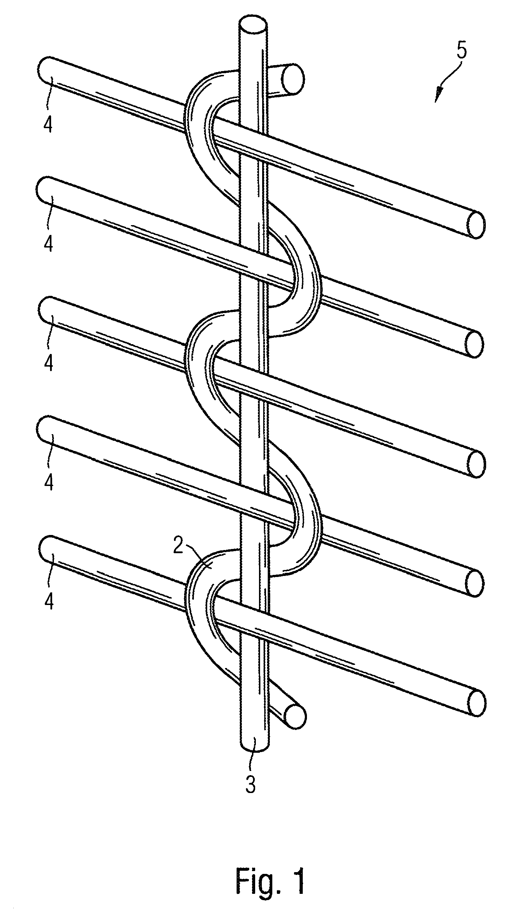

Bei heutigen Maschinentypen ist das Kettfadensystem dazu in zwei Kettfadensysteme unterteilt, beispielsweise in Steherkettfäden und Dreherkettfäden. Zur näheren Erläuterung wird in diesem Zusammenhang auf die Figur 1 verwiesen. Die Figur 1 zeigt ausschnittweise zwei Kettfäden 2, 3 des Gewebes 5, welche in Form einer Dreherbindung umfassend den Steherfaden 3, den Dreherfaden 2 sowie Schussfäden 4 eingewoben sind. Die Steherkettfäden 3 befinden sich in diesem Beispiel immer unterhalb der Schussfäden 4 und bilden daher beim Weben das Unterfach. Die Dreherkettfäden 2 bilden das Oberfach und befinden sich oberhalb der Schussfäden 4.

Der Zusammenhalt des Gewebes wird erreicht, indem der Dreherkettfaden 2 beim Schusseintrag einmal linksseitig und einmal rechtsseitig vom Steherfaden 3 einer Drehergruppe positioniert werden und sich die beiden Kettfadensysteme somit verkreuzen. Die besondere Form der Fadenverkreuzung erlaubt in Dreherbindungen sämtlicher Maschinentypen schiebefeste, gitterartige Gewebekonstruktionen mit offener Einstellung in Kett- und Schussrichtung.

Erfindungsgemäß können elektrische Leiter prinzipiell in beiden Kettfadensystemen oder als Schussfaden verarbeitet werden. Die Bildung eines elektrischen Kontakts erfolgt also über zwei beliebige Fadensysteme.

Dreherbindungen eignen sich besonders zur Herstellung des erfindungsgemäßen elektrisch leitfähigen textilen Flächengebildes, da neben der Materialpaarung und der Kontaktfläche auch die Parameter Kontaktdruck und räumliche Invarianz der Kontaktstellen für die Kontaktgüte zwischen den beiden Leitern von Bedeutung sind. Unter "räumlicher Invarianz der Kontaktstelle" wird in dieser Schrift die Eigenschaft einer Kontaktstelle zwischen elektrischen Leitern verstanden, die sich unter der applikationstypischen mechanischen Belastung des Textils geometrisch nicht bzw. nur unbedeutend verändert, verstanden. Eine unter elektrischer Last (Stromfluss über den Kontakt) stehende Kontaktstelle leidet beim Entfernen der Leiter voneinander bzw. bei Veränderung der Lage der Leiter zueinander. Das Erodieren führt zur Veränderung der Kontaktfläche (Form, Oxidation) und damit zum Verschleiß des Kontaktes. Die räumliche Invarianz des Kontaktes unter elektrischer und mechanischer Last ist für die Lebensdauer der elektrischen Verbindung von erheblicher Bedeutung.

Mit den meisten Textilbindungen kann in lockeren bzw. löchrig strukturierten Textilien kein hoher und konstanter Kontaktdruck erreicht werden. Insbesondere die räumliche Invarianz der Kontaktstellen kann nicht zuverlässig bereitgestellt werden. Die Verwendung von Dreherbindungen zum elektrischen Kontaktieren von Kett- und Schussfäden in textilen Flächengebilden bringt den für den elektrischen Kontakt erforderlichen hohen Kontaktdruck. Dreherbindungen zeichnen sich durch eine besonders feste Verankerung des Leiters in Schussrichtung auf dem Leiter in Kettrichtung aus. Die starke Verankerung resultiert im Wesentlichen aus der speziellen Verkreuzungsart bzw. der erhöhten Anzahl Fadenverkreuzungen innerhalb einer Bindungseinheit und ist durch die Parameter Fadenzugkraft, Reibungskoeffizient zwischen den Fäden und Umschlingungswinkel an den Fadenverkreuzungen bestimmt. Der Schussfaden wird im Unterschied zu anderen Gewebebindungen von sich umschlingenden Dreher- und Steherkettfäden abgebunden und somit an seiner Position gehalten. Ein Ausweichen in Richtung der eigenen Achse wird durch den aufgebauten Druck der Kettfäden verhindert, ein Ausweichen in Kettrichtung durch die Kettverkreuzungen vor und nach dem Schuss.

Dadurch kann eine zuverlässige Kontaktstelle zwischen den Leitern auch in lockeren bzw. löchrigen Gewebekonstruktionen erreicht werden. Ein weiterer Vorteil bezüglich der Kontaktgüte besteht in der einstellbaren Einarbeitung von Kett- und Schussfäden für definierte Kraft-Dehnungs-Eigenschaften des Textils bzw. definierte Bedingungen an den Kontaktstellen bei Zugbelastung.

Die Anwesenheit von elektrisch leitenden Kombinationsgarnen in der Dreherbindung gewährleistet die Konstanz des Kontaktdrucks und die räumliche Invarianz der Kontaktstelle und ermöglicht so die für zahlreiche Anwendungen erwünschte lockere bzw. löchrige textile Struktur.

Das erfindungsgemäße elektrisch leitfähige Textil zeichnet sich also durch einen sicheren und dauerhaften elektrischen Kontakt zwischen den Zuleitern und den Heizleitern aus. Diese Eigenschaften werden durch den Einsatz zumindest eines elektrisch leitfähigen Kombinationsgarns als Heizleiter, das durch eine Dreherbindung mit den Zuleitern in Kontakt steht, gewährleistet.

Durch die Verwendung der Dreherbindung können elektrische Leiter direkt im Flächenbildungsverfahren und ohne weiteren Arbeitsschritt eingearbeitet werden. Das erfindungsgemäße elektrisch leitfähige textile Flächengebilde weist ohne weitere Stabilisierung eine hohe Belastbarkeit und sehr typische textile Eigenschaften wie z.B. textile Haptik auf.

Die oben genannten wesentlichen Einflussfaktoren für die Kontaktgüte (Widerstand und Stromtragfähigkeit) im textilen Umfeld, nämlich Materialpaarung (Oberfläche, Härte, Leitfähigkeit, Korrosionsbeständigkeit), Kontaktfläche, Druck auf die Kontaktfläche (Größe und Konstanz) und räumliche Invarianz der Kontaktstelle, werden durch den erfindungsgemäßen Einsatz von elektrisch leitfähigen Kombinationsgarnen optimiert. Der Einsatz von Kombinationsgarnen sorgt für eine dauerhafte Beständigkeit der Heizleiter und ihrer elektrischen Eigenschaften unter mechanischer Belastung. Das elektrisch leitfähige Textil erhält in seiner Gesamtheit neben sehr typischen textilen Eigenschaften wie z.B. textile Haptik eine hohe mechanische Belastbarkeit und kann dadurch in zahlreichen Anwendungen eingesetzt werden.

Gemäß einer bevorzugten Ausführungsform der vorliegenden Erfindung wird daher zumindest ein Schussfaden durch ein elektrisch leitfähiges Kombinationsgarn gebildet. Ebenfalls bevorzugt ist es, wenn zumindest ein Kettfaden durch ein elektrisch leitfähiges Kombinationsgarn gebildet wird. Besondere Vorteile bezüglich der Güte der Kontaktstellen ergeben sich, wenn sowohl zumindest ein Schussfaden als auch zumindest ein Kettfaden durch elektrisch leitfähige Kombinationsgarne gebildet werden.

Eine geeignete Gruppe von Kombinationsgarnen sowie Verfahren zu deren Herstellung sind beispielsweise in der DE 103 42 787 A1 angegeben. Die Umwindegarne der DE 103 42 787 A1 enthalten metallische Drähte als elektrisch leitfähige Komponente.

Gemäß einer besonders bevorzugten Ausführungsform der vorliegenden Erfindung umfasst ein elektrisch leitfähiges Kombinationsgarn zumindest einen Kernfaden, zumindest einen, um den Kernfaden gewundenen elektrisch leitfähigen Faden und zumindest einen, um den Kernfaden gewundenen Umwindefaden.

Gemäß einer weiteren bevorzugten Ausführungsform der vorliegenden Erfindung sind der elektrisch leitfähige Faden und der Umwindefaden gegensinnig um den Kernfaden gewickelt. In einem textilen Flächengebilde mit Dreherbindung ist es besonders wichtig, dass das Garn kein inneres Drehmoment aufweist, das zu einer Verdrillung des Garns führt. Durch ein gestrecktes Garn ohne inneres Drehmoment kann die Verarbeitung zu einem textilen Flächengebilde in vorteilhafter Weise sicher gestellt werden.

Kombinationsgarne im Sinne der vorliegenden Erfindung sind Garne mit textilen Anteilen und metallischen Anteilen, die mittels Umwinden, Umwirbeln, Zwirnen etc. miteinander verbunden werden. Die Kombinationsgarne zeichnen sich je nach Materialzusammenstellung und Garnkonstruktion durch eine mehr oder weniger starke Ausprägung folgender Eigenschaften aus:
- textiler Griff und textile Optik,
- elastische, kontrollierbare Dehnbarkeit bei uneingeschränkter elektrischer Leitfähigkeit,
- hohe Reißfestigkeit und Biegsamkeit,
- hohe Waschbeständigkeit der leitfähigen Anteile.

Daher weisen leitfähige Textilien, in die elektrisch leitfähige Kombinationsgarne eingearbeitet sind, eine besonders hohe Belastbarkeit auf. Im Gegensatz zum Einsatz metallischer Drähte werden Kombinationsgarne nicht als Fremdkörper im Textil empfunden. Das entstehende Textil besitzt sehr typische textile Eigenschaften in Griff und Optik.

Als Kernfaden der Kombinationsgarne haben sich Elastomere, insbesondere Lycra^{™} in einer Stärke von 800 bis 5000 dtex, als geeignet herausgestellt, da sie den Garnen hohe Flexibilität, Elastizität und mechanische Beständigkeit verleihen. Die Garne werden gegen Zug-, Druck- und laterale Belastungen geschützt.

Als leitfähige Komponente in den Kombinationsgarnen werden bevorzugt Drähte aus Edelstahl, versilbertem Kupfer oder reinem Silber genutzt. Daneben können aber auch andere Metalle bzw. zusätzliche Beschichtungen in vorteilhafter Weise zum Einsatz kommen. Die Drähte können als Monofilament oder im Bündel, z.B. als Litze vorliegen. Die Durchmesser der Drähte liegen typischerweise zwischen 10 und 100 µm, wobei der Bereich zwischen 20 und 80 µm bevorzugt ist.

Gemäß einer weiteren bevorzugten Ausführungsform umfasst das elektrisch leitfähige Kombinationsgarn zumindest einen Kernfaden, zumindest ein, um den Kernfaden gewundenes elektrisch leitfähiges Multifilamentgarn und zumindest einen, um den mit dem elektrisch leitfähigen Multifilamentgarn umwundenen Kernfaden gewundenen äußeren Umwindefaden, wobei das elektrisch leitfähige Multifilamentgarn aus wenigstens zwei im Wesentlichen parallel laufenden Einzelfilamenten besteht. Durch die Verwendung von leitfähigen Multifilamentgarnen wird sichergestellt, dass das Kombinationsgarn an seiner Oberfläche eine besonders gute Leitfähigkeit aufweist, was wiederum Vorteile bei der Kontaktierung mit einer weiteren elektrisch leitfähigen Komponente mit sich bringt.

Besonders bevorzugt umfasst das elektrisch leitfähige Multifilamentgarn metallisierte, textile Filamente, metallisch beschichtete Synthesefilamente, silberbeschichtete Filamente, silberbeschichtete Nylonfilamente, Edelstahlfilamente, metallische Filamente, versilberte Kupferfilamente und/oder Silberfilamente, wobei die Einzelfilamente des elektrisch leitfähigen Multifilamentgarns bevorzugt einen Durchmesser zwischen 10 µm und 100 µm, besonders bevorzugt einen Durchmesser zwischen 20 µm und 60 µm und insbesondere bevorzugt einen Durchmesser zwischen 30 µm und 50 µm aufweisen.

Textile Umwindungen bestehen bevorzugt aus synthetischen Multifilament-Garnen, besonders bevorzugt aus Polyester im Bereich von 25 dtex bis 500 dtex. Sie können direkt auf den textilen Kern oder als äußere Umwindung über der metallischen Umwindung aufgebracht werden, um den textilen Charakter des Garns zu verstärken.

Die äußere Umwindung sollte das darunter liegende Garn für eine gute Kontaktierung nur teilweise abdecken. Bevorzugt entfällt die äußere Umwindung für Heizanwendungen vollständig.

Erfindungsgemäß sind in das elektrisch leitfähige Textil stromzuführende Leiter (Zuleiter) integriert. Es umfasst zwei elektrische Zuleiter und mindestens einen Heizleiter, der den zugeleiteten elektrischen Strom in Wärme umsetzt und somit einen höheren elektrischen Widerstand aufweist als der Zuleiter.

Elektrisch leitfähige Garne im Sinne der Erfindung sind alle auf Textilmaschinen verarbeitbaren leitfähigen Materialien wie metallische Drähte, Geflechte und Zwirne, leitfähige Stapelfaser-Garne, Kohlenstofffasern, leitfähig beschichtete Synthesefasern, leitfähige gefüllte Fasern sowie leitfähige Polymere. Elektrisch leitfähige Garne können ebenfalls die oben beschriebenen Kombinationsgarne sein.

Bevorzugte Ausführungsformen sind beispielsweise Edelstahl-Zwirne oder versilberte Kupfer-Zwirne, Bekinox^{™}-Garne der Fa. Bekaert oder Shieldex^{™}-Garne der Fa. Statex.

Das textile Flächengebilde enthält eine so genannte Buzz-Bar, die von mindestens einem Zuleiter-Garn, bevorzugt jedoch von mehreren nebeneinander liegenden Zuleiter-Garnen, gebildet wird. Zwei Buzz-Bars, die in definiertem Abstand zueinander in das Textil eingebracht sind, stehen beide mit mindestens einem Heizleiter-Garn in elektrisch leitendem Kontakt.

Als Zuleiter-Garne können sowohl elektrisch leitfähige Kombinationsgarne als auch elektrisch leitfähige Garne zum Einsatz kommen. Die Heizleiter-Garne bestehen aus elektrisch leitfähigen Kombinationsgarnen, die sich von den Zuleiter-Garnen hauptsächlich durch ihre elektrische Leitfähigkeit unterscheiden.

Für Zuleiter-Garne werden bevorzugt Drähte oder Litzen aus versilbertem Kupfer bzw. reinem Silber eingesetzt. Die leitfähige Komponente der Heizleiter-Garne muss einen höheren elektrischen Widerstand aufweisen, so dass bevorzugt Edelstahl verwendet wird. Die Heizleiter- und Zuleiter-Garne werden über die Dreherbindung zu einem beständigen Kontakt miteinander verbunden.

Bevorzugt ist das erfindungsgemäße elektrisch leitfähige Textil besonders dünn und/oder leicht bzw. löchrig ausgeführt, d.h. es behält auch bei großen Maschenweiten seine Kontaktstabilität.

### Wege zur Ausführung der Erfindung

### Beispiel 1 (nicht Teil der Erfindung):

Beim Einsatz eines erfindungsgemäßen elektrisch leitfähigen Flächengebildes als textile Heizung werden mindestens zwei Zuleiter-Garne in der Kette des Steherfadensystems eingebracht, die jeweils mit mindestens einem Heizleiter-Garn im Schuss kontaktiert werden. Die Anzahl der Zuleiter-Garne in der Kette, sowie der Heizleiter-Garne im Schuss werden je nach angestrebter Heizleistung festgelegt, wobei sämtliche Zuleiter-Garne einer Buzz-Bar direkt nebeneinander, sämtliche Heizleiter-Garne allerdings in festgelegtem Abstand zueinander eingearbeitet werden.

Zur Kontaktierung beider Leiter wird der leitende Schussfaden jeweils über der gesamten Steherkette mit leitenden und nichtleitenden Garnen eingebracht und bevorzugt mittels dünner monofiler Fäden in der Dreherkette fest mit den Steherkettfäden verankert. Bevorzugt erfahren Steherkettfäden und Schussfäden dabei kaum Einwebung. Eine geringe Einwebung der Steherkette kann insbesondere für hohe Schussdichten und ein reproduzierbares Kraft-DehnungsVerhalten des Textils vorteilhaft sein.

Die Produktionsrichtung kann auch so gedreht werden, dass die Heizleiter-Garne im Kettfadensystem und die Zuleiter-Garne als Schussfäden eingearbeitet werden.

### Beispiel 2 (nicht Teil der Erfindung):

Beim Einsatz eines erfindungsgemäßen elektrisch leitfähigen Flächengebildes als textile Heizung können die Zuleiter-Garne auch in die Kette des Dreherfadensystems eingebracht werden, um so die besondere Führung dieses Fadensystems für die Kontaktgüte zu nutzen. Indem die Zuleiter-Garne in der Dreherkette um die Heizleiter-Garne im Schuss geschlungen werden, kann die Kontaktfläche zwischen Zuleiter-Garnen und Heizleiter-Garnen erhöht werden. Diese Führung des leitenden Garns kann auch besonders vorteilhaft sein, wenn es sich bei den Zuleiter-Garnen um weniger dehnbare/elastische Materialien handelt, die nicht vollkommen gestreckt in das Textil eingearbeitet werden sollen.

Die Produktionsrichtung kann auch so gedreht werden, dass die Heizleiter-Garne im Kettfadensystem und die Zuleiter-Garne als Schussfäden eingearbeitet werden.

### Beispiel 3 (nicht Teil der Erfindung):

Beim Einsatz eines erfindungsgemäßen elektrisch leitfähigen Flächengebildes als textile Heizung werden die Zuleiter-Garne als Dreherpaare eingearbeitet, d.h. sowohl in der Steher- als auch in der Dreherkette an gleicher Stelle der Gesamtkette angeordnet. Hierbei kann einerseits auf einen zweiseitigen Kontakt mit dem Heizleiter im Schussfadensystem und damit auf eine erhöhte Kontaktgüte abgezielt werden. Andererseits resultiert bei Angleichen der Fadenspannung der beiden Kettsysteme im Gegensatz zu Beispiel 2 eine zusätzliche Einarbeitung der Steherkette. Diese Einarbeitung führt in einem bestimmten Bereich des Schussdichtegrads zu erhöhten Umschlingungen und damit zur Erhöhung der Schiebefestigkeit.

Die Produktionsrichtung kann auch so gedreht werden, dass die Heizleiter-Garne in beiden Kettfadensystemen und die Zuleiter-Garne als Schussfäden eingearbeitet werden.

### Beispiel 4:

Ein Heiztextil wird mit zwei unterschiedlich leitfähigen elastischen Kombinationsgarnen bzw. Umwindegarnen in Dreherbindung gebildet.

Das Zuleiter-Garn weist einen Lycra-Kern in der Stärke 1880 dtex, eine erste Umwindung aus Multifilament-Polyestergarn (PES) (110 dtex) und eine zweite Umwindung aus einer versilberten Kupferlitze (6+1*0,04 mm) auf. Mehrere nebeneinander liegende Zuleiter-Garne bilden im Textil eine Buzz-Bar.

Das Heizleiter-Garn ist in seinen textilen Bestandteilen identisch aufgebaut, enthält als leitende Komponente allerdings einen Edelstahl-Draht in der Stärke 0,05 µm und weist daher einen höheren elektrischen Widerstand auf.

In das Textil werden an zwei Stellen im Abstand von 250 mm (Fertigbreite) jeweils 10 Zuleiter-Garne als Buzz-Bar eingearbeitet. Dafür bilden je 5 Zuleiter-Garne in der Steherkette und 5 Zuleiter-Garne in der Dreherkette, die an der gleichen Stelle in die Kettfadensysteme eingeordnet sind, 5 Dreherpaare. Alle übrigen Dreherkettfäden sind PES-Monofile, die restliche Steherkette wird von PES-Multifilament-Garnen gebildet. Eine je nach Heizleistung definierte Anzahl von Heizleiter-Garnen wird im Abstand von 3,5 mm als Schuss eingearbeitet. Als Füllschussfäden zwischen zwei Heizleiter-Garnen werden jeweils 3 PES-Multifilamentgarne genutzt.

Die Verankerung der Schussfäden auf den Steherkettfäden erfolgt über die Fäden der Dreherkette. Zuleiter-Garne und Heizleiter-Garne bilden einen dauerhaften elektrischen Kontakt.

### Beispiel 5:

Ein Heiztextil wird mit den Kombinationsgarnen gemäß Beispiel 4 hergestellt. Im Textil werden jeweils 20 Zuleiter-Garne nebeneinander zu einer Buzz-Bar angeordnet, die zweimal im Abstand von 255 mm (Fertigbreite), in der Steherfadenkette einzubringen ist. Der Rest der Steherfadenkette ist mit geeigneten, unelastischen, nicht leitenden Kettfäden (PES-Multifilamentgarne) aufgefüllt. Die Heizleiter-Garne werden im Abstand von 1,55 mm als Schussfäden eingearbeitet, auf weitere Füllschussgarne wird verzichtet.

Die Verankerung der Schussfäden auf den Steherkettfäden erfolgt über die dünnen Monofilfäden der Dreherkette, deren Spannung für eine geringe Einwebung von Kett- und Schussfäden angepasst werden. Zuleiter-Garne und Heizleiter-Garne stehen in elektrischem Kontakt.

## Patentansprüche

1. Elektrisch leitfähiges textiles Flächengebilde zum Einsatz als textile Heizung mit zwei in definiertem Abstand zueinander als Zuleiter-Garne in das Flächengebilde integrierten Buzz-Bars und mindestens einem Heizleiter-Garn, wobei beide Buzz-Bars mit dem mindestens einem Heizleiter-Garn in elektrisch leitendem Kontakt stehen, wobei das mindestens ein Heizleiter-Garn einen höheren elektrischen Widerstand aufweist als die Zuleiter-Garne, und wobei es sich bei dem mindestens einen Heizleiter-Garn um ein elektrisch leitfähiges Kombinationsgarn handelt, das zumindest einen Kernfaden und zumindest einen um den Kernfaden gewundenen elektrisch leitfähigen Faden umfasst, **dadurch gekennzeichnet, dass** der Kernfaden aus einem Elastomer besteht und dass das mindestens ein Heizleiter-Garn und die Zuleiter-Garne über eine Dreherbindung in einem beständigen Kontakt miteinander verbunden sind.

2. Elektrisch leitfähiges textiles Flächengebilde nach Anspruch 1, **dadurch gekennzeichnet, dass** als elektrisch leitfähiger Faden ein monofiler Metalldraht oder eine Litze aus Edelstahl, versilbertem Kupfer oder aus Silber verwendet wird.

3. Elektrisch leitfähiges textiles Flächengebilde nach einem der Ansprüche 1 und 2, **dadurch gekennzeichnet, dass** es sich bei dem textilen Flächengebilde um ein Gewebe umfassend Kettfäden und Schussfäden handelt, wobei zumindest ein Schussfaden durch ein elektrisch leitfähiges Kombinationsgarn gebildet wird.

4. Elektrisch leitfähiges textiles Flächengebilde nach einem der Ansprüche 1 und 2, **dadurch gekennzeichnet, dass** es sich bei dem textilen Flächengebilde um ein Gewebe umfassend Kettfäden und Schussfäden handelt, wobei zumindest ein Kettfaden durch ein elektrisch leitfähiges Kombinationsgarn gebildet wird.

5. Elektrisch leitfähiges textiles Flächengebilde nach einem der vorhergehenden Ansprüche, **dadurch gekennzeichnet, dass** das elektrisch leitfähige Kombinationsgarn zuzätzlich zumindest einen, um den Kernfaden gewundenen Umwindefaden umfasst.

6. Elektrisch leitfähiges textiles Flächengebilde nach Anspruch 5, **dadurch gekennzeichnet, dass** der elektrisch leitfähige Faden und der Umwindefaden gegensinnig um den Kernfaden gewickelt sind.

## Claims

1. An electrically conductive textile fabric for deployment as a textile heating with two bus bars integrated into the fabric as feeder yarns at a defined spacing from one another and at least one heat conductor yarn, wherein both bus bars are in electrically conducting contact with the at least one heat conductor yarn, wherein the at least one heat conductor yarn has a higher electrical resistance than the feeder yarns, and wherein the at least one heat conductor yarn is an electrically conductive combination yarn, which comprises at least one core thread and at least one electrically conductive thread wound about the core thread, **characterised in that** the core thread consists of an elastomer and **in that** the at least one heat conductor yarn and the feeder yarns are connected with one another in durable contact via a leno weave.

2. The electrically conductive textile fabric according to claim 1, **characterised in that** a monofilament metal wire, or a strand of stainless steel, silvered copper, or silver, is used as an electrically conductive thread.

3. The electrically conductive textile fabric according to one of the claims 1 and 2, **characterised in that** the textile fabric is a weave comprising warp threads and weft threads, wherein at least one weft thread is formed by an electrically conductive combination yarn.

4. The electrically conductive textile fabric according to one of the claims 1 and 2, **characterised in that** the textile fabric is a weave comprising warp threads and weft threads, wherein at least one warp thread is formed by an electrically conductive combination yarn.

5. The electrically conductive textile fabric according to one of the preceding claims, **characterised in that** the electrically conductive combination yarn further comprises at least one winding thread wound about the core thread.

6. The electrically conductive textile fabric according to claim 5, **characterised in that** the electrically conductive thread and the winding thread are wound about the core thread in opposite directions.

## Revendications

1. Ensemble de surface textile électroconducteur pour utilisation en tant que chauffage textile avec deux bars omnibus intégrées dans l'ensemble de surface à un intervalle défini l'une de l'autre en tant que fils conducteurs d'alimentation et au moins un fil thermoconducteur, les deux bars omnibus se trouvant en contact électroconducteur avec au moins un fil thermoconducteur, au moins un fil thermoconducteur présentant une résistance électrique plus élevée que les fils conducteurs d'alimentation et pour lequel concernant au moins un fil thermoconducteur il s'agit d'un fil combiné électroconducteur qui comprend au moins un fil à âme et au moins un fil électroconducteur enroulé autour du fil à âme **caractérisé en ce que** le fil à âme est composé d'un élastomère et **en ce qu'**au moins un fil thermoconducteur et les fils conducteurs d'alimentation sont reliés entre eux par une armure gaze en contact stable.

2. Ensemble de surface textile électroconducteur selon la revendication 1 **caractérisé en ce qu'**un fil métallique monofil ou une lice en acier spécial, cuivre argenté ou en argent est utilisé comme fil électroconducteur.

3. Ensemble de surface textile électroconducteur selon une quelconque des revendications 1 et 2 **caractérisé en ce qu'**il s'agit pour l'ensemble de surface textile d'un tissu comprenant des fils de chaîne et des fils de trame, au moins un fil de trame étant formé par un fil combiné électroconducteur.

4. Ensemble de surface textile électroconducteur selon une quelconque des revendications 1 et 2 **caractérisé en ce qu'**il s'agit pour l'ensemble de surface textile d'un tissu comprenant des fils de chaîne et des fils de trame, au moins un fil de chaîne étant formé par un fil combiné électroconducteur.

5. Ensemble de surface textile électroconducteur selon une quelconque des revendications précédentes **caractérisé en ce que** le fil combiné électroconducteur comprend en plus au moins un fil guipé enroulé autour du fil à âme.

6. Ensemble de surface textile électroconducteur selon la revendication 5 **caractérisé en ce que** le fil électroconducteur et le fil guipé sont enroulés en sens inverse autour du fil à âme.
